# FASCICULE DE BREVET EUROPEEN

(11) **EP 0 519 784 B1**
(45) Date de publication et mention de la délivrance du brevet: **28.06.1995**
(21) Numéro de dépôt: 92401596.9
(22) Date de dépôt: 10.06.1992
(51) Int. Cl.: G02B 1/10

(54) **Procédé d'élaboration d'une structure optique et structure optique ainsi réaliseé**
Verfahren zur Herstellung einer optischen Struktur und damit hergestellte optische Struktur
Method of manufacturing of an optical structure and optical structure thus obtained

(30) Priorité: 12.06.1991 FR 9107140
(43) Date de publication de la demande: 23.12.1992
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Rostaing, Jean-Christophe, F-78000 Versailles (FR); Coeuret, François, F-78280 Guyancourt (FR)
(74) Mandataire: Le Moenner, Gabriel

(56) Documents cités:
- EP-A- 0 254 205
- EP-A- 0 291 113
- WO-A-88/08439
- US-A- 4 927 704

## Description

L'invention concerne l'élaboration d'une structure optique à base de substrat polymère optique.

Les polymères optiques sont de plus en plus utilisés en remplacement du verre ou pour des applications spécifiques nouvelles. Cet intérêt est suscité en premier lieu par leur facilité de mise en forme, mais également leur légèreté et éventuellement leur résistance au choc. Cependant ils ont l'inconvénient de présenter une résistance assez médiocre à l'usure mécanique, ainsi qu'à certains agents de dégradation physique et chimique dans les conditions d'utilisation. Leur surface doit donc impérativement être protégée par des revêtements durs transparents.

Dans certains cas, en outre, on doit prévoir des revêtements aptes à conférer des fonctionnalités optiques au produit fini, qui mettent en jeu autant les propriétés intrinsèques du film que son interaction avec le substrat, et notamment le comportement mécanique de l'interface.

Les exigences les plus généralement imposées par les utilisateurs concernent :
- l'adhésion,
- la résistance à l'abrasion, notamment vis-à-vis du maintien des propriétés optiques,
- la tenue aux cyclages et aux chocs thermiques,
- l'inertie à certains agents atmosphériques ou chimiques, en fonction de l'application envisagée.

Les spécifications optiques peuvent consister en un simple critère de transparence dans le visible ou inclure des fonctions plus complexes.

Certains polymères, notamment le polycarbonate, subissent également un vieillissement accéléré lorsqu'ils sont exposés au rayonnement ultraviolet (U.V.) ambiant en conditions normales d'utilisation. Lorsqu'un revêtement a été déposé sur ces polymères, la dégradation de l'interface conduit à une détérioration encore beaucoup plus rapide du produit avec des délaminations spectaculaires. En un tel cas, le revêtement doit donc assurer une fonction de filtrage des rayons U.V.

D'une manière générale, ces structures optiques doivent répondre à des tests accélérés sévères, nombreux et diversifiés et plus ou moins spécifiques aux utilisateurs.

Les revêtements protecteurs classiquement appliqués par voie liquide offrent peu de souplesse dans la modulation de leurs propriétés, qui sont en général imposées par la molécule de précurseur considérée. Il est très difficile de synthétiser des composés conduisant à des revêtements capables de satisfaire à l'ensemble des exigences requises, et en outre il est par nature impossible de réaliser des fonctions optiques autres que la simple transparence dans le visible par exemple.

Actuellement on cherche à remplacer ces solutions liquides par des matériaux inorganiques amorphes à base de silicium, déposés à partir d'une phase gazeuse. La mise en oeuvre du silane nécessitant certaines précautions de sécurité, on s'est tout d'abord orienté vers des procédés dits de "polymérisation plasma" à partir de composés organosiliciés non pyrophoriques comme l'hexaméthyldisiloxane. Ce dernier est non seulement le vecteur de silicium, mais apporte également les autres éléments constitutifs de la couche (O, C, H) d'une manière relativement peu contrôlable même en recourant à des apports additionnels d'oxygène (O₂) par exemple.

Jusqu'ici les procédés de dépôts selon le procédé dit de dépôt chimique en phase vapeur amélioré par plasma ("plasma enhanced chemical vapor deposition" désigné plus loin par son abréviation usuelle "P.E.C.V.D.."), à partir de silane sur polymères ont relativement peu exploité les potentialités offertes. Si des matériaux de bonne dureté ont été réalisés (SiO₂), la réalisation des fonctions adhérence et tenue thermique nécessite souvent le recours à un primaire d'adhérence appliqué par voie liquide qui diminue beaucoup l'intérêt économique du procédé. De plus ces revêtements assurent une fonction de protection uniquement, sans que l'on ait cherché à leur conférer des fonctionnalités optiques.

Toujours dans cette catégorie de dépôt par P.E.C.V.D., on peut citer le document WO-A-8 808 439, déposé au nom de la demanderesse, qui décrit un procédé de dépôt d'une couche protectrice de type SᵢCₓN_{y}O_{z}Hₜ sur substrat polymère, où l'on procéde avantageusement avant dépôt, à un prétraitement plasma de la surface du substrat pour nettoyer cette surface et favoriser l'adhésion du dépôt ultérieur (voir préambule des revendications 1 et 2).

Selon l'expérience de la demanderesse, le dépôt réalisé selon de document, qui est une monocouche, s'il réalise une fonction efficace de protection, combine difficilement toutes les propriétés nécessaires d'adhésion, de dureté, de résistance au cyclage thermique ou encore de fonctionnalité optique.

La présente invention vise à réaliser, en fonction de différentes exigences des utilisateurs, des revêtement sur polymères possédant à la fois des qualités d'adhésion, de tenue thermique, d'inertie physico-chimique, et le cas échéant un certain nombre de fonctionnalités optiques. Même si l'on exclut ces dernières, il s'avère qu'il n'existe généralement pas de matériau de revêtement pouvant à lui seul satisfaire à ces différents critères et la solution technologique retenue repose donc sur une structure composite multicouche plus ou moins complexe.

L'invention vise donc à disposer d'un ensemble de matériaux de couches présentant des propriétés d'association entre eux et avec le substrat polymérique, pouvant permettre d'assembler une structure répondant à l'ensemble des spécifications requises.

Les procédés de dépôt "P.E.C.V.D." à partir de vecteurs indépendants des différents éléments (SiH₄, O₂, N₂, C₂H₂...) permettent d'élaborer de manière souple et bien contrôlée une très large gamme d'alliages amorphes de silicium. Il est souvent possible pour un matériau donné d'optimiser une ou plusieurs propriétés, notamment les suivantes:
- adhésion
- tenue thermomécanique
- résistance à l'abrasion
- propriétés optiques
- inertie physico-chimique

Cette distinction est assez arbitraire, car il est, par exemple, évident que l'adhésion est liée aux propriétés thermomécaniques.

De même, les tests en abrasion rendent compte non seulement de la dureté intrinsèque de la couche, mais aussi dans une certaine mesure de l'adhésion lorsque des particules abrasives de taille importante tendent à rayer profondément, voir à arracher la couche. L'inertie physico-chimique peut mettre en jeu aussi bien les propriétés des matériaux de films que celles des interfaces.

Néanmoins, il est possible d'attribuer à chaque niveau de couche une fonction principale.

Les meilleurs résultats ont été obtenus par l'invention selon les revendications 1 et 2, dans une procédé connu où l'on assure sur un substrat polymérique optique, un revêtement à base d'alliage de silicium en mettant en oeuvre au moins les phases opératoires suivantes :
a) on effectue un traitement d'activation de la surface du substrat par plasma à base d'un mélange gazeux contenant de l'argon;
b) on dépose au moins une couche de dureté à base d'alliage de silicium par ladite technique P.E.C.V.D. à partir de silane et d'oxygène.

Si l'on considère l'aspect adhésion, qui procède essentiellement de la nature du substrat, de la préparation de sa surface, de la composition et de la microstructure du matériau se trouvant au contact du polymère, il s'avère que les alliages amorphes de silicium adhérent médiocrement sur une surface polymérique sans préparation particulière. Pour assurer une bonne cohésion, un traitement d'activation de la surface est donc effectué, avec la contrainte supplémentaire pour les matériaux optiques de respecter la transparence de l'interface, et le traitement est un traitement par plasma utilisé d'ailleurs dans les phases ultérieures du procédé de l'invention. Le choix des gaz et des paramètres de procédé dépend du polymère considéré.

Alors que le "PMMA" et son dérivé greffé imide "KAMAX™" supportent sans dommage un plasma très oxydant (Ar/O2 par exemple), le polycarbonate est rapidement dégradé par ce dernier avec carbonisation partielle et apparition d'une coloration brunâtre. En revanche le polycarbonate n'est pas dégradé optiquement par un traitement argon puis argon/ammoniac, tel que décrit dans les brevets FR 2614317 et FR 2631346. Ce procédé a été optimisé pour le polycarbonate, mais donne également d'excellents résultats sur polystyrène, "ABS" et "CR 39". Les performances sont moins bonnes sur "PMMA" et "KAMAX™", pour lesquels on préfère un plasma Ar/O₂.

Il s'est avéré que le simple dépôt d'une couche structurelle dure de SiO₂ par exemple sur un substrat activé comme indiqué précédemment, est adhérent mais se dégrade dès le début des tests thermiques. La tenue thermomécanique dépend certes des caractéristiques de la couche dure, mais on a mis en évidence qu'il est impossible de satisfaire aux tests sans recourir à une couche intermédiaire. Selon l'invention on procède au dépôt d'une couche par PECVD à partir uniquement de silane et d'un gaz plasmagène ou diluant (Ar, He), d'environ 10 nm (100 Å) d'épaisseur. Le matériau déposé ne peut être considéré comme un silicium amorphe hydrogéné, car le substrat polymérique interagit chimiquement avec la couche au cours de la croissance et participe à sa composition. Le film reste cependant riche en silicium, mais du fait de sa très faible épaisseur, aucune absorption optique parasite dans le visible n'est observable.

Cette couche intermédiaire peut en particulier être réalisée dans un plasma micro-ondes en post-décharge, conformément au procédé décrit dans le brevet FR 2631346.

D'autres couches intermédiaires peuvent être nécessaires pour satisfaire aux tests thermiques en fonction des caractéristiques des autres constituants de l'empilement.

En général, les couches assurant une fonction optique présentent des caractéristiques incompatibles avec leur emploi simultané comme couches protectrices dures. L'empilement à fonction optique, s'il y a lieu, est donc réalisé après les couches d'adhésion et avant le dépôt de la ou les couches structurelles dures. Il faut noter que ces dernières ont une certaine influence sur la fonction de transmission du système complet, ce dont il est naturellement tenu compte au niveau de la conception des couches optiques.

Comme exemple de fonction optique, on peut citer les filtres passe-bas à coupure abrupte. Une de leurs applications, bien qu'il ne s'agisse plus là à proprement parler d'une fonctionnalité optique du produit, est la protection d'un substrat en polycarbonate contre le rayonnement UV.

Le choix du matériau de couche dure est déterminé certes par des considérations de dureté, mais également de tenue thermomécanique et d'inertie physicochimique. La composition n'est d'ailleurs pas seule en cause, le mode de préparation pouvant influer considérablement sur la microstructure.

Comme on l'a dit précédemment, la dégradation des revêtements à la suite de fortes variations thermiques (plusieurs dizaines de degrés) résulte des contraintes élevées générées du fait de la très grande dissymétrie des coefficients d'expansion thermique de la couche et du substrat. Lorsque l'échantillon est réchauffé par rapport à l'ambiante, la contrainte augmente dans le sens tensif avec un risque de dégradation de type craquelure et/ou faïençage. Au contraire, lorsque l'échantillon est refroidi, la contrainte évolue dans le sens compressif ce qui, au-delà d'un certain niveau, peut conduire à des décollements étendus ou à un "éclatement" du film.

L'occurrence de dégradations au cours d'un test défini dépend principalement, quoique non exclusivement, d'une part du niveau maximal de contrainte atteint dans chaque sens et d'autre part des propriétés de résistance mécanique des couches et des interfaces constituant le revêtement.

Le premier aspect est réglé par les valeurs des coefficients de dilatation et des modules d'élasticité, ainsi que des contraintes intrinsèques.

Le second aspect est influencé non seulement par la nature et la composition des matériaux, mais aussi par leur microstructure et celle de leurs interfaces. On conçoit intuitivement qu'une structure granulaire et discontinue favorise l'initiation des ruptures. D'une manière générale les films déposés à température ambiante sans bombardement ionique ont une structure nettement colonnaire résultant d'un réarrangement insuffisant des atomes de la couche en cours de croissance.

Cependant l'influence fine de la microstructure dans les mécanismes de dégradation n'a pas jusqu'ici été clairement mise en évidence. En premier lieu, il semble que les résultats en terme de tenue thermomécanique soient spectaculairement améliorés par la maîtrise des contraintes intrinsèques, également via le bombardement ionique.

Pour simplifier, le bombardement ionique permet d'ajuster le niveau de la contrainte compressive intrinsèque (c'est-à-dire mesurée à la température de dépôt), de façon à effectuer une "translation d'origine". De la sorte, l'amplitude de la contrainte totale (intrinsèque et thermique) peut être maintenue au cours du test dans des limites compatibles avec l'intégrité de la structure.

La valeur de cette "correction" de contrainte dépend des caractéristiques du matériau de couche, de sa contrainte intrinsèque en l'absence de bombardement ionique et de la fenêtre de température couverte sur le test.

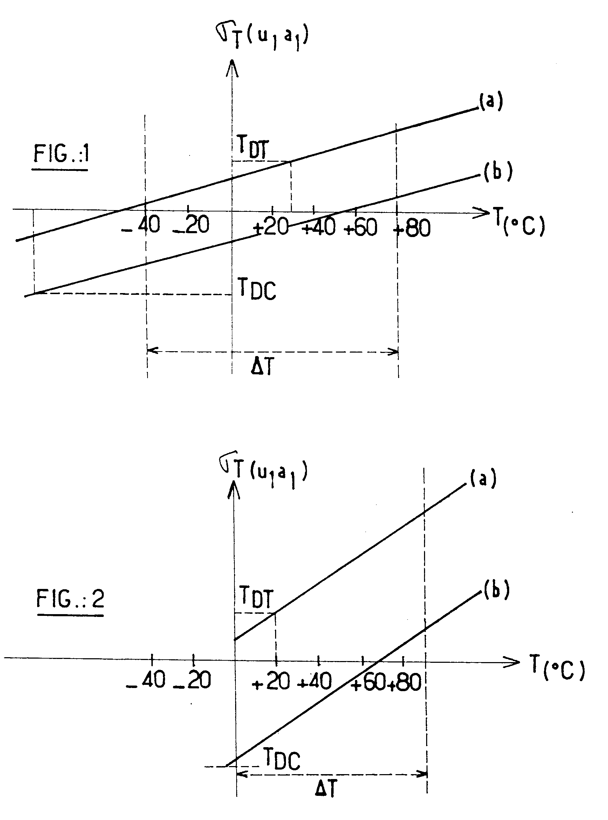

Le principe de l'obtention d'échantillons résistant aux cyclages thermiques par ajustement des contraintes intrinsèques est illustré par les figures 1 et 2, où l'on a porté la variation qualitative de la contrainte totale (intrinsèque + thermique) d'un film déposé sans (a) et avec (b) polarisation radiofréquence. σ_{T} en ordonnée est comptée positivement dans le sens tensif.

T_{DT} et T_{DC} désignent des températures moyennes de dégradation des échantillons par excès de contrainte tensive et compressive, respectivement.

ΔT est l'extension de la plage de test en température.

La figure 1 correspond au cas d'un dépôt monocouche, par exemple de nitrure de silicium Si₃N₄, sur un substrat de polycarbonate, le test thermique étant du type en vigueur dans l'industrie automobile (-40°C, + 80°C).

La figure 2 concerne le même type de film déposé sur un substrat de CR39, dont le coefficient d'expansion thermique est environ deux fois plus élevé que celui du polycarbonate. Le test thermique considéré, en vigueur dans certaines industries optiques, porte sur une gamme de température différente (0,90°C).

Dans les deux cas, on comprend aisément comment l'ajustement des contraintes intrinsèques permet de rester en deçà des limites de dégradation au cours du test thermique.

La faisabilité pratique implique d'avoir un certain degré d'indépendance entre le contrôle du bombardement ionique et celui de la génération des précurseurs de dépôt.

L'invention est fondée sur la considération de trois types de matériaux de couche dure : oxyde, nitrure, oxynitrure de silicium. Ces matériaux sont dits "quasi-stoechiométriques". Il peut y avoir une ambiguïté dans le sens où ils contiennent des quantités notables d'hydrogène. On peut cependant lever cette ambiguïté en démontrant qu'il s'agit de matériaux contenant une très faible proportion de liaison Si-Si, d'ailleurs sans influence sur les propriétés utiles et très difficilement mesurables.

La silice SiO₂ :H est conseillée pour les applications ne nécessitant pas une très grande dureté. Sans mise en oeuvre d'une polarisation radio-fréquence (RF) le matériau déposé est neutre ou modérément compressif et présente d'excellentes propriétés thermomécaniques. L'inertie physicochimique est également excellente.

Le nitrure de silicium amorphe hydrogéné Si₃N₄ :H présente une grande dureté, mais le matériau déposé est, naturellement, assez fortement tensif et son comportement thermomécanique est médiocre.

On note également que le matériau colonnaire est peu résistant au brouillard salin.

Le bombardement ionique permet d'une part de corriger les contraintes dans le sens compressif et d'autre part d'améliorer la microstructure jusqu'à disparition totale de l'aspect colonnaire. En fait, les propriétés thermomécaniques s'avèrent réellement excellentes si l'on réalise une bicouche en interposant un film de SiO₂ du type précédent entre la couche d'adhésion et le nitrure.

Dans ce cas, le revêtement obtenu montre les mêmes performances que celui en SiO₂ seul. L'inertie chimique, la tenue en ambiance humide et saline sont en particulier substantiellement améliorées.

Le nitrure de silicium présente cependant l'inconvénient d'un indice de réfraction élevé qui accroît la visibilité des figures d'interférence en cas d'inhomogénéité d'épaisseur. On peut obtenir des matériaux de dureté proche de celle du nitrure mais d'indice plus faible en incorporant une certaine quantité d'oxygène, ce qui en outre peut également permettre un contrôle des contraintes. En particulier, un oxynitrure déposé sans polarisation du substrat peut posséder d'excellentes propriétés thermomécaniques.

L'oxynitrure de silicium apparaît donc comme une solution intermédiaire, en particulier dans les cas où la polarisation radiofréquence est difficilement applicable (objets de forme gauche complexe). Il faut également noter qu'il peut être dégradé par le brouillard salin.

Selon une solution de l'invention, on revêt la couche de SiO₂ d'un film, selon ladite technique P.E.C.V.D. et sous polarisation radio-fréquence, à partir d'azote, d'oxygène et de silane SiH₄, d'une seconde couche complexe de composition intermédiaire entre SiO₂ et Si₃N₄, avec un minimum de liaisons Si-Si.

On donne ci-après quelques exemples de réalisations.

Dans ce qui suit, les paramètres de procédé éventuellement cités se rapportent à un réacteur de laboratoire micro-ondes post-décharge développé par L'AIR LIQUIDE.

Le procédé s'applique plus particulièrement au polycarbonate (PC), mais il donne également de bons résultats sur les autres polymères optiques, en particulier le polystyrène, l'ABS, le CR39, le PMMA et la KAMAX™. Il comprend en séquence les opérations suivantes:
- un prétraitement Ar, puis Ar/NH₃,
- un dépôt d'une couche d'adhésion riche en silicium à partir de SiH₄ et Ar, d'épaisseur 10 nm (100 Å) environ,
- dépôt d'une couche structurelle dure SiO₂, d'épaisseur 3 à 5 »m.

Sur PMMA et KAMAX™, le prétraitement consiste préférablement en un plasma Ar/O₂.

Les tests consistent en 10 cycles thermiques en atmosphère sèche +25°C→-40°C→+80°C→+25°C à 2°C/min, puis 10 autres cycles en atmosphère saturée d'humidité. Le résultat est positif sur PC, PMMA, KAMAX, CR39. Les échantillons sur PC résistent en outre à 3 chocs thermiques -40°C→+80°C.

Pour les revêtements durs bicouche silice et nitrure, les épaisseurs respectives des deux films dépendent des spécifications à la fois en résistance à l'abrasion et en comportement thermomécanique. Dans la majorité des cas l'épaisseur de SiO₂ est de 2 à 3 »m, de même que celle de Si₃N₄. Pour la configuration la plus employée, notamment pour les glaces de phares ou les glaces de custode d'automobile, l'épaisseur est de 3»m et 3»m respectivement.

Pour les verres ophtalmiques, les tests sont différents et une épaisseur de SiO₂ de 3 »m et une épaisseur de nitrure de 2 »m apparaît comme étant la meilleure solution:

On opère de la façon suivante :
- prétraitement Ar/O₂ (PMMA, KAMAX™) ou Ar + Ar/NH3 (autres polymères),
- couche d'adhésion riche en silicium 10 nm (100 Å)
- couche intermédiaire SiO₂ hors polarisation 2 à 3»m,
- couche structurelle dure Si₃N₄ sous polarisation 2 à 3 »m.

En utilisant la polarisation RF, on obtient sur tous polymères optiques des dépôts tenant 10 cycles thermiques secs. Sur polycarbonate, un revêtement réalisé sans polarisation tient également 10 cycles, tandis qu'un échantillon fabriqué en utilisant la polarisation résiste également à 3 chocs thermiques.

Sur PMMA et KAMAX™ le dépôt hors polarisation fournit également des échantillons tenant 10 cycles thermiques.

La tenue aux tests thermiques en humidité et en immersion est également bonne.

Cependant, il peut s'avérer utile que la couche de revêtement final soit une couche déposée à partir d'azote, d'oxygène et de silane SiH₄ de façon à former une composition intermédiaire entre SiO₂ et Si₃N₄ avec un minimum de liaisons Si-Si.

Quelle que soit la structure de la couche finale, on détermine la polarisation radio-fréquence, ou bombardement ionique, de façon à ajuster la contrainte compressive de la couche à la température ambiante.

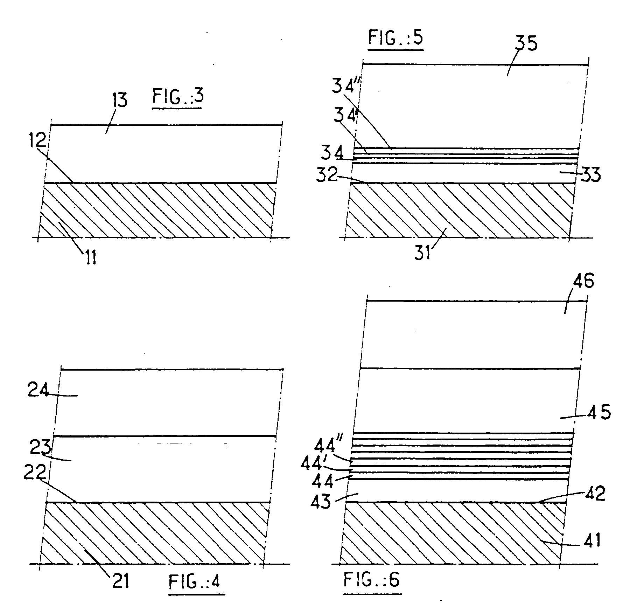

En se référant aux dernières pages annexées dont les figures 3 à 6 sont des coupes de quatre structures optiques selon l'invention:
- Selon la figure 3, sur un substrat optique 11, on procède à une activation de surface en 12, puis au dépôt d'un film 13 constitué substantiellement de SiO₂ d'épaisseur de 2 à 3 »m.
- Selon la figure 4, on procède sur un substrat 21 à une activation de surface 22, puis aux dépôts d'un premier film 23 de SiO₂ d'épaisseur de 3 »m, puis d'un second film 24 à base de Si₃N₄/SiOₓN_{y} d'épaisseur de trois »m.
- Selon la figure 5, on procède sur un substrat 31 à une activation de surface en 32, puis aux dépôts successifs d'une couche intermédiaire 33 de SiO₂ d'épaisseur de 200 nm (2000 Å), puis plusieurs couches anti-ultraviolet 34, 34′, 34˝... et finalement une couche de dureté 35 de SiO₂ d'épaisseur comprise entre 3 et 5 »m.
- Selon la figure 6, on procède sur un substrat 41 à une activation de surface en 42, puis aux dépôts successifs d'une couche intermédiaire 43, à base de SiO₂ d'épaisseur de 200 nm (2000 Å), puis plusieurs couches anti-UV 44, 44′, 44˝..., ensuite une couche de SiO₂ d'épaisseur 45 et de 3 »m et finalement une couche à base de Si₃N₄/SiOₓN_{y} de trois »m.

## Revendications

1. Procédé d'élaboration d'une structure optique, du genre où l'on assure, sur un substrat polymère optique (11, 21, 31, 41), un revêtement à base d'alliage de silicium (13), comportant les phases opératoires successives suivantes :
a) on effectue un traitement d'activation de la surface (12, 22, 32, 42) du substrat (11, 21, 31, 41) par plasma à base d'un mélange gazeux contenant de l'argon,
b) on dépose au moins une couche de dureté à base d'alliage de silicium (13, 23, 35, 45) par technique PECVD à partir de silane et d'oxygène, caractérisé en ce que ladite couche de dureté est de SiO₂ dont l'épaisseur est de l'ordre de 2 à 5 »m et en ce que postérieurement à l'étape b), on effectue une étape c) au cours de laquelle on revêt ladite couche de SiO₂, selon ladite technique PECVD, sous polarisation radio-fréquence, d'une seconde couche (24, 26) formée de Si₃N₄, ou de SiN_{y}H_{z}, ladite seconde couche ayant une épaisseur de 2 à 5 »m.

2. Procédé d'élaboration d'une structure optique, du genre ou l'on assure, sur un- substrat polymère optique (11, 21, 31, 41), un revêtement à base d'alliage de silicium (13), comportant les phases opératoires successives suivantes :
a) On effectue un traitement d'activation de la surface (12, 22, 32, 42) du substrat (11, 21, 31, 41) par plasma à base d'un mélange gazeux contenant de l'argon,
b) on dépose au moins une couche de dureté à base d'alliage de silicium (13, 23, 35, 45) par technique PECVD à partir de silane et d'oxygène, caractérisé en ce que ladite couche de dureté est de SiO₂ dont l'épaisseur est de l'ordre de 2 à 5 »m et en ce que postérieurement à l'étape b), on effectue une étape c) au cours de laquelle on revêt ladite couche de SiO₂, selon ladite technique PECVD et sous polarisation radio-fréquence, d'une seconde couche (46) complexe de composition intermédiaire entre SiO₂ et Si₃N₄ avec un minimum de liaisons Si-Si.

3. Procédé selon l'une des revendications 1 à 2 caractérisé en ce que ladite technique PECVD est pratiquée à partir d'un mélange de précurseurs gazeux compris dans l'ensemble constitué de N₂, O₂, SiH₄.

4. Procédé selon l'une des revendications 1 à 3, caractérisé en ce qu'on dépose sur le substrat (31, 41) et avant dépôt de la couche de SiO₂ (35, 45), selon la technique PECVD et à partir de silane, une couche intermédiaire (33, 43).

5. Procédé selon la revendication 4, caractérisé en ce qu'on dépose entre ladite couche intermédiaire (33, 43) et la couche de SiO₂ (35, 45), une ou plusieurs couches (34, 34′, 34˝-44, 44′, 44˝) à fonctionnalité optique, par exemple du type adsorptif et/ou interférentiel.

6. Procédé selon la revendication 4 ou 5, caractérisé en ce que la couche intermédiaire (33, 43) a une épaisseur d'au moins 100 A et inférieure à une épaisseur d'apparition de coloration jaune.

7. Procédé selon l'une des revendications 1 à 6, caractérisé en ce qu'on effectue le traitement d'activation de surface (12, 22, 32, 42) avec un plasma du type Ar/O₂ ou Ar puis Ar/NH₃.

8. Procédé selon l'une des revendications 1 à 7, caractérisé en ce que la polarisation du substrat est déterminée de façon à ajuster la contrainte compressive de la seconde couche à la température ambiante.

## Patentansprüche

1. Verfahren zur Herstellung einer optischen Struktur, bei dem man auf einem optischen Polymersubstrat (11, 21, 31, 41) eine Beschichtung auf der Basis einer Siliziumlegierung (13) erzeugt, wobei das Verfahren die folgenden Schritte umfaßt:
a) Durchführen einer Aktivierungsbehandlung der Oberfläche (12, 22, 32, 42) des Substrats (11, 21, 31, 41) mittels Plasma auf der Basis eines Gasgemisches, welches Argon enthält,
b) Auftragen zumindest einer Hartschicht auf der Basis einer Siliziumlegierung (13, 23, 35, 45) mittels PECVD-Technik, ausgehend von Silan und Sauerstoff, dadurch gekennzeichnet, daß die Hartschicht aus SiO₂ besteht, dessen Dicke etwa 2 bis 5 »m ist, und daß nach dem Schritt b) ein Schritt c) durchgeführt wird, bei dem man die SiO₂-Schicht mit der PECVD-Technik bei Hochfrequenz-Polarisierung mit einer aus Si₃N₄ oder SiN_{y}H_{z} bestehenden zweiten Schicht (24, 26) beschichtet, wobei die zweite Schicht eine Dicke von 2 bis 5 »m hat.

2. Verfahren zur Herstellung einer optischen Struktur, bei dem man auf einem optischen Polymersubstrat (11, 21, 31, 41) eine Beschichtung auf der Basis einer Siliziumlegierung (13) erzeugt, wobei das Verfahren die folgenden Schritte umfaßt:
a) Durchführen einer Aktivierungsbehandlung der Oberfläche (12, 22, 32, 42) des Substrats (11, 21, 31, 41) mittels Plasma auf der Basis eines Gasgemisches, welches Argon enthält,
b) Auftragen zumindest einer Hartschicht auf der Basis einer Siliziumlegierung (13, 23, 35, 45) mittels PECVD-Technik, ausgehend von Silan und Sauerstoff, dadurch gekennzeichnet, daß die Hartschicht aus SiO₂ besteht, dessen Dicke in etwa 2 bis 5 »m ist, und daß nach dem Schritt b) ein Schritt c) durchgeführt wird, bei dem man die SiO₂-Schicht mit der PECVD-Technik und bei Hochfrequenz-Polarisierung mit einer zweiten Schicht (46) beschichtet, die eine komplexe Zusammensetzung hat, welche zwischen SiO₂ und Si₃N₄ liegt und ein Minimum an Si-Si-Bindungen hat.

3. Verfahren nach einem der Ansprüche 1 bis 2, dadurch gekennzeichnet, daß man bei der Durchführung der PECVD-Technik von einem Gemisch aus gasförmigen Vorläufern ausgeht, die zu der aus N₂, O₂, SiH₄ bestehenden Gruppe gehören.

4. Verfahren nach einem der Ansprüche 1 bis 3, dadurch gekennzeichnet, daß man auf dem Substrat (31, 41) und vor dem Auftragen der SiO₂-Schicht (35, 45) mit der PECVD-Technik, ausgehend von Silan, eine Zwischenschicht (33, 43) aufträgt.

5. Verfahren nach Anspruch 4, dadurch gekennzeichnet, daß man zwischen der Zwischenschicht (33, 43) und der SiO₂-Schicht (35, 45) eine oder mehrere Schichten (34, 34′, 34˝-44, 44′, 44˝) mit optischer Funktion, z.B. mit absorbierender und/oder Interferenzwirkung, aufträgt.

6. Verfahren nach Anspruch 4 oder 5, dadurch gekennzeichnet, daß die Zwischenschicht (33, 43) eine Dicke von mindestens 100 Å hat und kleiner ist als eine Dicke, bei der Gelbfärbung auftritt.

7. Verfahren nach einem der Ansprüche 1 bis 6, dadurch gekennzeichnet, daß man die Aktivierungsbehandlung der Oberfläche (12, 22, 32, 42) mit einem Plasma vom Typ Ar/O₂ oder Ar und daraufhin Ar/NH₃ durchführt.

8. Verfahren nach einem der Ansprüche 1 bis 7, dadurch gekennzeichnet, daß die Polarisierung des Substrats so vorgenommen wird, daß die Druckspannung der zweiten Schicht auf die Umgebungstemperatur eingestellt wird.

## Claims

1. Process for the preparation of an optical structure, of the type where a silicon-based alloy (13) coating is provided on an optical polymeric substrate (11, 21, 31, 41), comprising the following successive operating phases :
a) an activation treatment is carried out on the surface (12, 22, 32, 42) of the substrate, (11, 21, 31, 41) by means of a plasma based on a gaseous mixture containing argon,
b) at least one hard layer based on a silicon alloy (13, 23, 35, 45) is deposited by the PECVD technique from silane and oxygen, characterized in that the said hard layer is SiO₂ the thickness of which is of the order of 2 to 5 »m and in that subsequent to stage b), a stage c) is carried out during which the said SiO₂ layer is coated, by means of the said PECVD technique, under radio-frequency polarization, with a second layer (24, 26) formed of Si₃N₄ or SiN_{y}H_{z}, the said second layer having a thickness of 2 to 5 »m.

2. Process for the preparation of an optical structure, of the type where a silicon-based alloy (13) coating is provided on an optical polymeric substrate (11, 21, 31, 41), comprising the following successive operating phases :
a) an activation treatment is carried out on the surface (12, 22, 32, 42) of the substrate, (11, 21, 31, 41) by means of a plasma based on a gaseous mixture containing argon,
b) at least one hard layer based on a silicon alloy (13, 23, 35, 45) is deposited by the PECVD technique from silane and oxygen, characterized in that the said hard layer is SiO₂ the thickness of which is of the order of 2 to 5 »m and in that subsequent to stage b), a stage c) is carried out during which the said SiO₂ layer is coated, by means of the said PECVD technique, under radio-frequency polarization, with a second complex layer (46) having a composition intermediate between SiO₂ and Si₃N₄ with a minimum of Si-Si bonds.

3. Process according to either of claims 1 or 2, characterized in that the said PECVD technique is carried out starting with a mixture of gaseous precursors comprised within the set consisting of N₂, O₂, SiH₄.

4. Process according to one of claims 1 to 3, characterized in that an intermediate layer (33, 43) is deposited on the substrate (31, 41), and before deposition of the SiO₂ layer (35, 45), by means of the PECVD technique, and starting with silane.

5. Process according to claim 4, characterized in that one or more layers (34, 34′, 34˝-44, 44′, 44˝) with optical functionality, for example of the adsorptive and/or interferential type, are deposited between the said intermediate layer (33, 43) and the SiO₂ layer (35, 45).

6. Process according to claim 4 or 5, characterized in that the intermediate layer (33, 43) has a thickness of at least 100 Å and less than a thickness at which the colour yellow appears.

7. Process according to one of claims 1 to 6, characterized in that the activation treatment of the surface (12, 22, 32, 42) is carried out with a plasma of the type Ar/O₂ or Ar folowed by Ar/NH₃.

8. Process according to one of claims 1 to 7, characterized in that polarization of the substrate is determined so as to adjust the compressive stress in the second layer at room temperature.
